# FASCICULE DE BREVET EUROPEEN

(11) **EP 3 240 157 B1**
(45) Date de publication et mention de la délivrance du brevet: **25.10.2023**
(21) Numéro de dépôt: 17168115.8
(22) Date de dépôt: 26.04.2017
(51) Int. Cl.: H02K 11/02, H02K 11/33, F02B 39/10

(54) **FILTRE ELECTRONIQUE DESTINE A FILTRER LA PUISSANCE D'ALIMENTATION D'UN MOTEUR ELECTRIQUE**
ELEKTRONISCHER FILTER ZUM FILTERN DER ENERGIEEINSPEISELEISTUNG EINES ELEKTROMOTORS
ELECTRONIC FILTER FOR FILTERING THE POWER SUPPLY OF AN ELECTRIC MOTOR

(30) Priorité: 28.04.2016 FR 1653781
(43) Date de publication de la demande: 01.11.2017
(73) Titulaire: Valeo Systemes de Controle Moteur, 95800 Cergy Saint Christophe (FR)
(72) Inventeur: DUCHON, Rudy, 95800 Cergy Saint Christophe (FR); MERCIER, Philippe, 72300 Sable Sur Sarthe (FR)
(74) Mandataire: Valeo Powertrain Systems

(56) Documents cités:
- EP-A1- 2 133 569
- WO-A2-2011/073562
- DE-T5-112013 006 708
- US-A1- 2014 300 304

## Description

L'invention a pour objet un filtre électronique destiné à filtrer la puissance d'alimentation d'un moteur électrique.

L'invention se rapporte également à un convertisseur de tension comprenant un filtre électronique selon l'invention, à un équipement électrique comprenant un convertisseur de tension selon l'invention, et à un compresseur de suralimentation électrique comprenant un équipement électrique selon l'invention et destiné à comprimer les gaz d'admission dans un moteur thermique.

En général, un moteur électrique, notamment pour véhicule automobile, est alimenté en puissance par des modules électroniques de puissance. En particulier, un module électronique de puissance est alimenté en énergie électrique par une barre de connexion électrique.

Une telle barre de connexion électrique comprend un ensemble d'éléments électriques formant un filtre, de sorte à filtrer l'énergie électrique destinée à alimenter les modules électroniques de puissance. Plus précisément, la barre de connexion électrique comprend une ou plusieurs inductances et des condensateurs montés sur la barre de connexion électrique.

Le document EP 2 133 569 A1 décrit un filtre selon le préambule de la revendication 1. De l'état de la technique sont également connus les documents US 2014/300304 A1, WO 2011/073562 A2 et DE 11 2013 006708 T5.

Les condensateurs sont, en général, montés par sertissage sur la barre de connexion électrique. Cependant, le procédé de montage des condensateurs par sertissage nécessite des temps et des coûts de production importants. En effet, les condensateurs sont montés individuellement sur la barre de connexion électrique, ce qui nécessite une main d'oeuvre importante. De plus, le procédé de sertissage introduit des contraintes de placement des condensateurs sur la barre de connexion électrique, notamment à cause de la place nécessaire pour les outils permettant de réaliser le procédé de sertissage.

La présente invention vise à remédier à ces inconvénients en proposant un filtre électronique dans lequel des composants électriques de filtrage sont découplés entre une barre de connexion électrique et une carte électronique.

A cet effet, l'invention a pour objet un filtre électronique selon la revendication 1.

Une trace de puissance est par exemple une pièce conductrice électriquement, notamment métallique, par exemple en cuivre, ladite pièce pouvant être une lame métallique, ou un barreau métallique.

Avantageusement, les coûts et les temps de production d'un filtre électronique selon l'invention sont réduits, notamment grâce à une diminution des coûts et des temps de production de la barre de connexion électrique. En effet, la disposition des condensateurs du filtre électronique sur la carte électronique permet de réduire les dimensions de la barre de connexion électrique, en permettant notamment de supprimer les emplacements de la barre de connexion électrique recevant les condensateurs, ainsi que la place nécessaire pour le passage des outils permettant de connecter électriquement les condensateurs aux bornes de connexion des traces de puissance.

De plus, les condensateurs peuvent être implantés sur la carte électronique avec des procédés de fabrication automatiques qui ne nécessitent pas de main d'oeuvre importante comme l'implantation des condensateurs sur la barre de connexion électrique.

Le filtre électronique selon l'invention peut également comprendre une ou plusieurs des caractéristiques suivantes, considérées individuellement ou selon toutes les combinaisons possibles :
- le ou chaque condensateur est monté en surface sur la carte électronique ; et/ou
- les condensateurs sont montés en parallèle électriquement les uns avec les autres ; et/ou
- l'inductance est montée en série électriquement avec le ou chaque condensateur ; et/ou
- la barre de connexion électrique et la carte électronique sont agencées en vis-à-vis, de sorte que la borne de connexion de la au moins une trace de puissance s'étend depuis la barre de connexion électrique en direction de la carte électronique ; et/ou
- la borne de connexion de la au moins une trace de puissance s'étend de façon transversale, notamment de façon sensiblement perpendiculaire, depuis la barre de connexion électrique en direction de la carte électronique ; et/ou
- la borne de connexion étant en forme de broche, la carte électronique et la borne de connexion étant conformées de sorte que la borne de connexion est reliée électriquement à une piste électrique de la carte électronique connectée au condensateur ; et/ou
- la borne de connexion est soudée à la piste électrique par un procédé de vague sélective ; et/ou
- le matériau isolant électriquement de la barre de connexion électrique est un matériau plastique ; et/ou
- la ou les traces de puissance de la barre de connexion électrique sont des lames métalliques ; et/ou
- la ou les traces de puissance de la barre de connexion électrique sont des barreaux métalliques ; et/ou
- la carte électronique comprend un premier et un deuxième condensateurs, dans lequel la barre de connexion électrique comprend une première trace de puissance positive comprenant une borne de connexion connectée électriquement au premier condensateur, une première trace de puissance négative comprenant une borne de connexion connectée électriquement au premier condensateur, une deuxième trace de puissance positive comprenant une borne de connexion connectée électriquement au deuxième condensateur, et une deuxième trace de puissance négative comprenant une borne de connexion connectée électriquement au deuxième condensateur, et dans lequel l'inductance est connectée électriquement à chacune desdites première et deuxième traces de puissance ; et/ou
- la carte électronique comprend une pluralité de premiers condensateurs et une pluralité de deuxièmes condensateurs, dans lequel la barre de connexion électrique comprend une première trace de puissance positive comprenant une pluralité de bornes de connexion connectées électriquement respectivement à la pluralité de premiers condensateurs, une première trace de puissance négative comprenant une pluralité de bornes de connexion connectées électriquement respectivement à la pluralité de premiers condensateurs, une deuxième trace de puissance positive comprenant une pluralité de bornes de connexion connectées électriquement respectivement à la pluralité de deuxièmes condensateurs, et une deuxième trace de puissance négative comprenant une pluralité de bornes de connexion connectées électriquement respectivement à la pluralité de deuxièmes condensateurs, et dans lequel l'inductance est connectée électriquement à chacune desdites première et deuxième traces de puissance.

L'invention se rapporte également à un convertisseur de tension destiné à contrôler une énergie électrique échangée entre une machine électrique et une source d'alimentation électrique, comprenant un filtre électronique selon l'invention.

Le convertisseur de tension selon l'invention peut également comprendre une ou plusieurs des caractéristiques suivantes, considérées individuellement ou en combinaison :
- le convertisseur de tension comprend des interrupteurs électroniques configurés pour recevoir un courant échangé avec la machine électrique et une carte électronique de contrôle configurée pour contrôler les états desdits interrupteurs électroniques, ladite carte électronique de contrôle comprenant la carte électronique du filtre électronique ; et/ou
- une première partie de la carte électronique comprend ledit condensateur du filtre électronique et une deuxième partie de la carte électronique, différente de la première partie, comprend des composants destinés à contrôler les états desdits interrupteurs électroniques.

L'invention a également pour objet un équipement électrique comprenant une machine électrique et un convertisseur de tension selon l'invention, dans lequel le convertisseur de tension est monté sur la machine électrique.

L'invention se rapporte également à un compresseur de suralimentation électrique, notamment pour véhicule automobile, comprenant un équipement électrique selon l'invention.

D'autres caractéristiques et avantages de la présente invention apparaitront à la lecture de la description et des figures suivantes :
- les figures 1 et 2 sont deux vues d'une barre de connexion électrique selon l'invention,
- la figure 3 représente les traces de puissance sans surmoulage de la barre de connexion électrique des figures 1 et 2,
- la figure 4 représente une vue éclatée d'un filtre électronique selon l'invention,
- la figure 5 représente un filtre électronique selon l'invention, et
- la figure 6 représente un schéma électrique d'un filtre électronique selon l'invention, et
- les figures 7 et 8 représentent des vues respectivement partiellement en coupe et en coupe d'un compresseur de suralimentation électrique selon l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

L'invention a pour objet un filtre électronique, destiné à filtrer la puissance d'alimentation d'un équipement électrique, notamment embarqué dans un véhicule automobile.

Un tel filtre électronique comprend une barre de connexion électrique destinée à échanger une énergie électrique entre source d'alimentation électrique et une machine électrique.

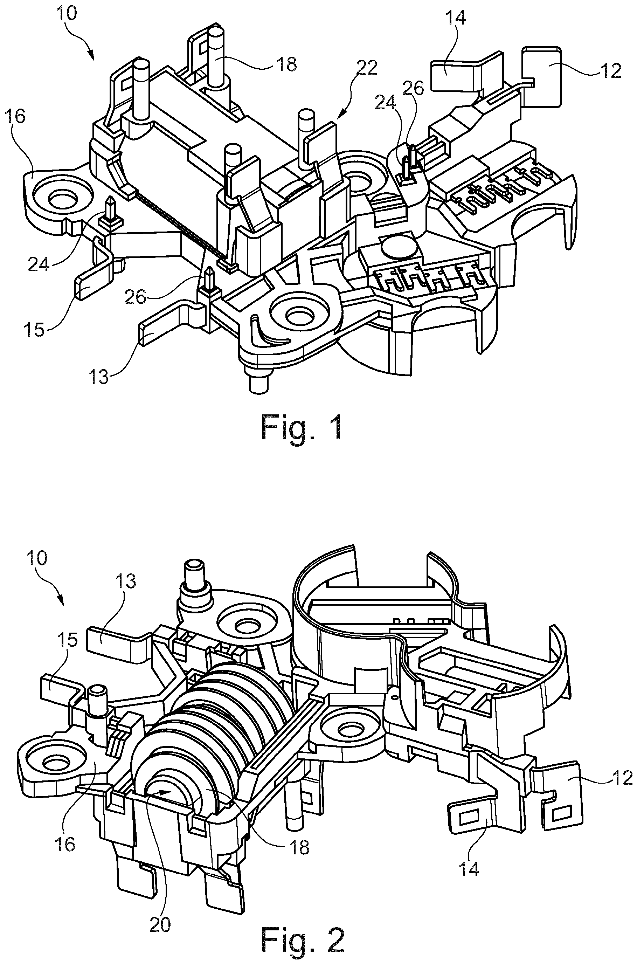

Une telle barre de connexion électrique 10 est représentée sur les figures 1 et 2. La barre de connexion électrique 10 comprend au moins une trace de puissance.

Une trace de puissance est une trace conductrice électriquement, notamment métallique, par exemple en cuivre. Une trace de puissance peut être une lame métallique, ou un barreau métallique.

Une trace de puissance est destinée à transmettre un courant électrique entre un réseau électrique et la machine électrique.

Le réseau électrique est, par exemple, un réseau électrique du véhicule automobile, notamment un réseau électrique alimenté par une tension électrique de +48V. De préférence, le réseau électrique est un réseau d'énergie électrique continue.

Par exemple, sur la figure 1, la barre de connexion électrique 10 comprend une trace de puissance 12 positive et une trace de puissance 14 négative.

La trace de puissance 12 positive est notamment destinée à être connectée électriquement à un pôle de polarité positive d'un réseau électrique d'un véhicule, par exemple à une tension électrique de +48V. La trace de puissance 14 négative est notamment destinée à être connectée électriquement à un pôle de polarité négative du réseau électrique, par exemple à une tension électrique de 0V.

Les traces de puissance positive et négative 12, 14 sont distinctes l'une de l'autre et sont en partie surmoulées de matériau isolant électriquement, par exemple de matériau plastique.

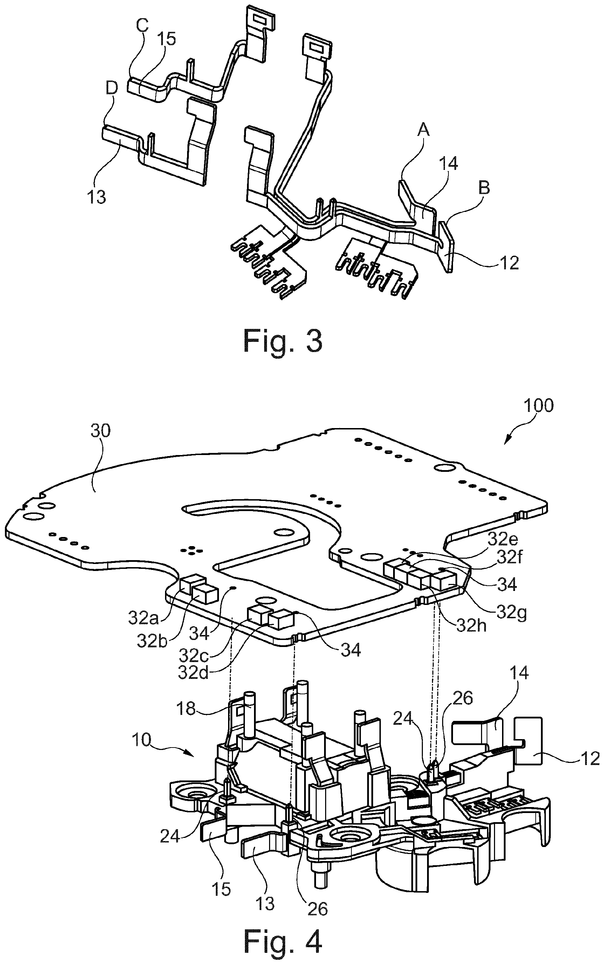

Par exemple, le surmoulage 16 des traces de puissance positive et négative 12, 14 est visible sur les figures 1 et 2, et les traces de puissance positive et négative 12, 14 représentées sans surmoulage sont visibles sur la figure 3.

La barre de connexion électrique 10 comprend également une inductance 18 connectée électriquement aux traces de puissance positive et négative 12, 14.

Par inductance, on entend tout composant électronique destiné par sa construction à avoir une valeur d'inductance prédéterminée. Par exemple, une inductance peut désigner une bobine, ou un solénoïde.

La barre de connexion électrique 10 peut également comprendre deux traces de puissance 13, 15, destinées à être connectées électriquement aux traces de puissance 12, 14. Plus précisément, les traces de puissance 13, 15 sont destinées à être connectées électriquement à l'inductance 18, l'inductance 18 étant destinée à être connectée électriquement aux traces de puissance 12, 14.

Les traces de puissance 12, 13, 14, 15 comprennent respectivement des bornes B, D, A, C, représentées sur la figure 3, destinées à être connectées à des éléments électriques extérieurs à la barre de connexion électrique 10.

La barre de connexion électrique 10, et notamment le surmoulage 16 des traces de puissance positive et négative 12, 14, peut comprendre une zone de réception 20, notamment visible sur la figure 2, conformée pour recevoir l'inductance 18.

L'inductance peut être montée à force dans la zone de réception 20. Autrement dit, la zone de réception 20 peut être conformée pour recevoir le composant électrique sans jeu. Avantageusement, la réception de l'inductance à force dans la zone de réception permet d'assurer une bonne tenue mécanique de l'inductance dans la zone de réception.

L'inductance peut être montée à nue, c'est-à-dire sans boitier, afin de diminuer l'encombrement de ladite inductance, et par conséquent afin de réduire les dimensions de la zone de réception, et donc les dimensions de la barre de connexion électrique.

La barre de connexion électrique 10, et notamment le surmoulage 16 des traces de puissance positive et négative 12, 14, peut comprendre une zone de connexion 22, notamment visible sur la figure 1, dans laquelle les traces de puissance positive et négative 12, 14 sont destinées à être connectées électriquement à l'inductance 18.

La zone de réception 20 et la zone de connexion 22 sont avantageusement séparées par le surmoulage 16, de sorte à permettre une protection de l'inductance lors de la connexion électrique de cette dernière aux traces de puissance. En effet, le surmoulage permet d'empêcher les projections métalliques générées lors de la connexion électrique, notamment par soudure, de l'inductance aux traces de puissance, notamment lorsque l'inductance est montée à nue dans la zone de réception.

Comme représenté sur la figure 2, la zone de réception 20 peut comprendre une paroi formant le fond de ladite zone de réception 20, et une paroi latérale s'étendant depuis ledit fond dans une direction sensiblement perpendiculaire par rapport audit fond. La paroi latérale peut s'étendre de façon continue autour de la zone de réception 20. De préférence, la paroi latérale a une hauteur comprise entre 50% et 75% de la hauteur de l'inductance. Une telle paroi permet avantageusement de protéger et de maintenir mécaniquement l'inductance, tout en garantissant une dissipation thermique de la chaleur générée par l'inductance.

Chaque trace de puissance positive et négative 12, 14 comprend au moins une borne de connexion 26, 24, notamment représentées sur la figure 1, destinées à être connectées électriquement à un ou plusieurs composants électriques extérieurs à la barre de connexion électrique 10. Les composants électriques peuvent être, par exemple, des composants de filtrage, tels que des condensateurs.

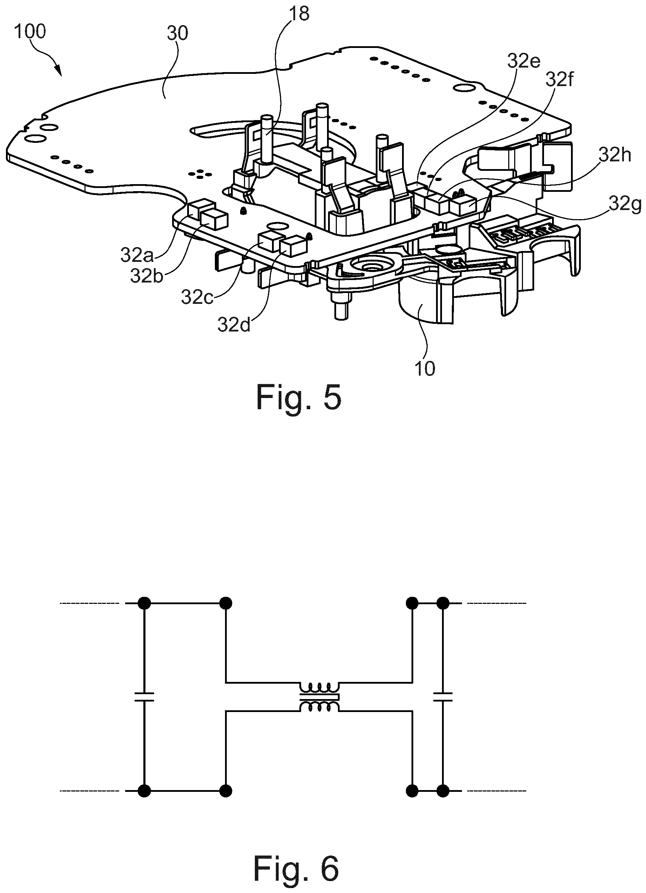

Le filtre électronique 100 comprend également une carte électronique 30. Un tel filtre électronique est notamment représenté sur les figures 4 et 5.

La carte électronique 30 comprend au moins un condensateur 32a-32h. Le condensateur 32a-32h de la carte électronique 30 est connecté électriquement à une borne de connexion 26 de la trace de puissance positive 12 et à une borne de connexion 24 de la trace de puissance négative 14 de la barre de connexion électrique 10.

La carte électronique 30 peut comprendre une pluralité de condensateurs 32a-32h, par exemple huit condensateurs sur les figures 4 et 5. Chaque condensateur 32a-32h de la carte électronique 30 est connecté électriquement à une borne de connexion 26 de la trace de puissance positive 12 et à une borne de connexion 24 de la trace de puissance négative 14 de la barre de connexion électrique 10, les bornes de connexion des traces puissance pouvant être les mêmes ou différentes pour chaque condensateur.

En particulier, la carte électronique 30 peut comprendre un premier condensateur 32a-32d et un deuxième condensateur 32e-32h. Un premier condensateur est, par exemple, un condensateur situé en amont de l'inductance 18 décrite précédemment, et un deuxième condensateur est, par exemple, un condensateur situé en aval de l'inductance 18 décrite précédemment. La direction amont-aval correspondant à une direction depuis le réseau électrique vers la charge à laquelle est connecté le filtre électronique.

La carte électronique 30 peut également comprendre une pluralité de premiers condensateurs 32a-32d et de deuxièmes condensateurs 32e-32h.

Les traces de puissance positive et négative 12, 14 peuvent comprendre respectivement une ou plusieurs bornes de connexion 26, 24 connectées électriquement au premier ou à chaque premier condensateur 32a-32d et à l'inductance 18. De même, les traces de puissance positive et négative 12, 14 peuvent également comprendre respectivement une ou plusieurs bornes de connexion 26, 24 connectées électriquement au deuxième ou à chaque deuxième condensateur 32e-32h et à l'inductance 18.

Le ou chaque condensateur 32a-32h peut être monté en surface, sur la carte électronique 30. Autrement dit, la carte électronique selon l'invention peut être fabriquée sur des lignes de production standard, utilisant le procédé de dépôt de composants en surface (« CMS »), ce qui réduit les coûts de production du filtre électronique.

Avantageusement, la disposition des condensateurs du filtre électronique sur la carte électronique permet de supprimer les emplacements de la barre de connexion électrique recevant les condensateurs, ainsi que la place nécessaire pour le passage des outils permettant de connecter électriquement les condensateurs aux bornes de connexion des traces de puissance.

La figure 6 représente un schéma électrique d'un filtre électronique selon l'invention.

Les condensateurs 32a-32d, 32e-32h peuvent être montés en parallèle électriquement les uns avec les autres.

L'inductance 18 peut être montée en série électriquement avec les condensateurs 32a-32d, 32e-32h. Par exemple, sur la figure 4, l'inductance 10 est destinée à être montée en série électriquement avec le groupe de condensateurs 32a-32d, et avec le groupe de condensateurs 32e-32h, chaque groupe de condensateur comprenant quatre condensateurs. En particulier, les condensateurs 32a-32d peuvent être montés en parallèle électriquement les uns avec les autres et l'ensemble de ces condensateurs est monté en série avec l'inductance 18. De même, les condensateurs 32e-32h peuvent être montés en parallèle électriquement les uns avec les autres et l'ensemble de ces condensateurs est monté en série avec l'inductance 18.

Comme représenté sur la figure 4, la barre de connexion électrique 10 et la carte électronique 30 sont agencées en vis-à-vis.

En particulier, les bornes de connexion 26, 24 des traces de puissance positive et négative 12, 14 s'étendent, notamment de façon transversale, par exemple de façon sensiblement perpendiculaire, depuis la barre de connexion électrique 10 en direction de la carte électronique 30.

La carte électronique comprend des orifices 34 recevant les bornes de connexion 24, 26. En particulier, les bornes de connexion 24, 26 peuvent être en forme de broche.

La carte électronique peut comprendre une ou plusieurs pistes électriques connectées aux condensateurs 32a-32h.

La carte électronique 30 et les bornes de connexion 24, 26 peuvent être conformées de sorte que les bornes de connexion 24, 26 peuvent être reliées électriquement à la ou à chaque piste électrique de la carte électronique 30.

Les bornes de connexion 24, 26 peuvent être soudées à la ou à chaque piste électrique par un procédé de vague sélective, ou par tout autres moyens, tels que par exemple une vague totale, une soudure électrique, une brasure au fer à souder ou au laser.

L'invention se rapporte également à un compresseur de suralimentation électrique, notamment pour véhicule automobile, comprenant un équipement électrique.

L'équipement électrique comprend une machine électrique et un convertisseur de tension. En particulier, le convertisseur de tension est monté sur la machine électrique.

Le convertisseur de tension est destiné à contrôler une énergie électrique échangée entre la machine électrique et une source d'alimentation électrique.

Le convertisseur de tension comprend un filtre électronique tel que de décrit précédemment.

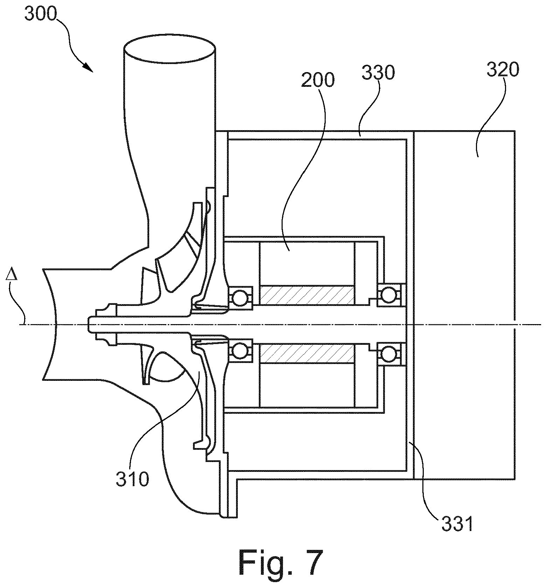

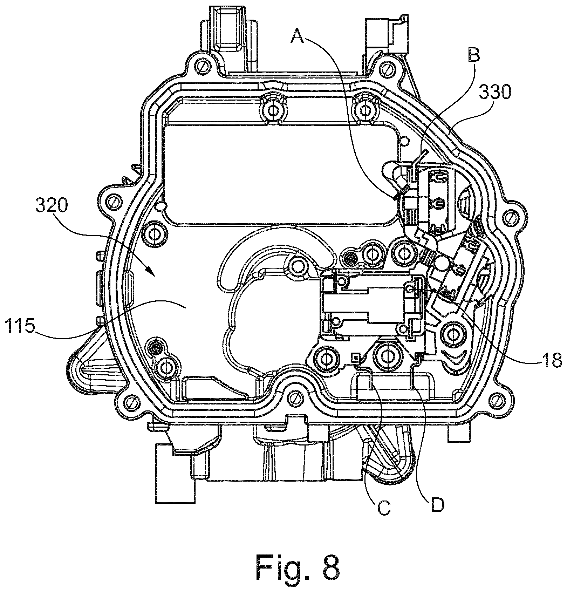

Les figures 7 et 8 illustrent un exemple de compresseur de suralimentation électrique 300 comprenant le convertisseur de tension 320 et la machine électrique 200, notamment une machine électrique tournante. Notamment, le compresseur de suralimentation électrique 300 est configuré pour être embarqué dans un véhicule pour comprimer les gaz d'admission du moteur à combustion du véhicule. En particulier, le réseau électrique est un réseau électrique du véhicule et comprend une batterie alimentant ledit réseau électrique. Le compresseur de suralimentation 300 comprend une roue de compression 310 destinée à comprimer l'air d'admission d'un moteur à combustion en association duquel le compresseur de suralimentation électrique 300 est monté. La roue de compression 310 est entraînée en rotation par la machine électrique 200. Notamment, le compresseur de suralimentation 300 peut comprendre un boitier 330 qui comporte la roue de compression 310, la machine électrique 200 et le convertisseur de tension 320. Ce boitier 330 peut être en plusieurs parties qui se montent les unes sur les autres pour former le boitier 330.

Dans le convertisseur de tension 320, le filtre électronique peut être monté sur une surface 115. Cette surface 115 est notamment perpendiculaire à l'axe de rotation Δ de la machine électrique 200. En particulier, la surface 115 de support peut être une face d'une paroi qui sépare deux logements du boitier 330. Par exemple, la surface 115 de support peut être une face d'une paroi 331 séparant un logement du boitier 330 comprenant le convertisseur de tension 320 d'un autre logement comprenant la machine électrique 200. Le filtre électronique est notamment connecté électriquement à des composants électroniques (non représentés) qui commandent l'énergie échangée avec la machine électrique 200, pour alimenter ces composants électroniques. Le filtre électronique peut être connecté à ces composants électroniques par l'intermédiaire de bornes A, B, notamment représentées sur les figures 3 et 8, situées en aval de l'inductance 18 décrite précédemment. Le filtre électronique est notamment connecté au réseau électrique par des bornes C, D, notamment représentées sur les figures 3 et 8, situées en amont de l'inductance 18 décrite précédemment.

Dans l'exemple illustré en figures 7 et 8, la machine électrique 200 se trouve notamment entre le convertisseur de tension 320 et la roue de compression 310. Le convertisseur de tension 320 est ainsi placé à une extrémité axiale du compresseur de suralimentation électrique 300. Un capot peut venir fermer le convertisseur de tension 320 en venant en appui sur le boitier 330. La machine électrique 200 peut être positionnée le long de l'axe de rotation Δ entre le convertisseur de tension 320 et la roue de compression 310, c'est-à-dire entre une zone axiale correspondant au convertisseur de tension 320 et une zone axiale correspondant à la roue de compression 310. Cependant, l'agencement de la roue de compression 310, de la machine électrique 200 et du convertisseur de tension 320 peut être différent. Par exemple, le convertisseur de tension 320 peut être placé entre la machine électrique 200 et la roue de compression 310.

Le convertisseur de tension peut également comprendre des interrupteurs électroniques.

Les interrupteurs électroniques sont configurés pour recevoir un courant échangé avec la machine électrique et une carte électronique de contrôle. La carte électronique de contrôle est configurée pour contrôler les états desdits interrupteurs électroniques.

De préférence, la carte électronique de contrôle comprend la carte électronique du filtre électronique.

En particulier, la carte électronique peut comprendre une première partie et une deuxième partie, la deuxième partie étant différente de la première partie. La première partie de la carte électronique peut comprendre le ou chaque condensateur du filtre électronique et la deuxième partie de la carte électronique comprend des composants électriques destinés à contrôler les états desdits interrupteurs électroniques.

## Revendications

1. Un filtre électronique (100), destiné à filtrer la puissance d'alimentation d'un équipement électrique, notamment embarqué dans un véhicule automobile, comprenant :
- une barre de connexion électrique (10) destinée à échanger une énergie électrique entre une source d'alimentation électrique et une machine électrique, la barre de connexion électrique (10) comprenant :
- une trace de puissance positive (12) et une trace de puissance négative (14) destinées à transmettre un courant électrique entre un réseau électrique et la machine électrique, la trace de puissance positive (12) et la trace de puissance négative (14) comprenant chacune au moins une borne de connexion (24, 26) et étant en partie surmoulées de matériau isolant électriquement (16),
- une inductance (18) connectée électriquement aux traces de puissance positive (12) et négative (14),
- une zone de réception (20) conformée pour recevoir ladite inductance (18), **caractérisé en ce que** le filtre électronique (100) comporte :
- une carte électronique (30) comprenant des orifices (34) recevant ladite au moins une borne de connexion (24, 26) de la trace de puissance positive (12) et ladite au moins une borne de connexion de la trace de puissance négative (14) et au moins un condensateur (32a-32h),
le au moins un condensateur (32a-32h) de la carte électronique (30) étant connecté électriquement à ladite au moins une borne de connexion (24, 26) de la trace de puissance positive (12) et à ladite au moins une borne de connexion de la trace de puissance négative (14) de la barre de connexion électrique (10).

2. Filtre électronique selon la revendication 1, dans lequel le condensateur (32a-32h) est monté en surface sur la carte électronique (30).

3. Filtre électronique selon l'une des revendications précédentes, dans lequel la barre de connexion électrique (10) et la carte électronique (30) sont agencées en vis-à-vis, de sorte que les bornes de connexion (24, 26) des traces de puissance positive et négative (14, 12) s'étendent depuis la barre de connexion électrique (10) en direction de la carte électronique (30).

4. Filtre électronique selon la revendication précédente, dans lequel les bornes de connexion (24, 26) des traces de puissance positive et négative (24, 26) s'étendent de façon transversale, notamment de façon sensiblement perpendiculaire, depuis la barre de connexion électrique (10) en direction de la carte électronique (30).

5. Filtre électronique selon la revendication 3 ou 4, dans lequel les bornes de connexion sont en forme de broche, la carte électronique (30) et les bornes de connexion (24, 26) sont conformées de sorte que les bornes de connexion (24, 26) sont reliées électriquement à des pistes électriques de la carte électronique (30) connectée au condensateur (32a-32h).

6. Filtre électronique selon l'une des revendications précédentes, dans lequel la carte électronique (30) comprend un premier et un deuxième condensateurs (32a-32d, 32e-32h), dans lequel la barre de connexion électrique (10) comprend une première trace de puissance (12) positive comprenant une borne de connexion (26) connectée électriquement au premier condensateur (32a-32d), une première trace de puissance négative (14) comprenant une borne de connexion (24) connectée électriquement au premier condensateur (32a-32d), une deuxième trace de puissance (12) positive comprenant une borne de connexion (26) connectée électriquement au deuxième condensateur (32e-32h), et une deuxième trace de puissance (14) négative comprenant une borne de connexion (24) connectée électriquement au deuxième condensateur (32e-32h), dans lequel l'inductance (18) est connectée électriquement à chacune desdites première et deuxième traces de puissance (12, 14).

7. Convertisseur de tension (320) destiné à contrôler une énergie électrique échangée entre une machine électrique (200) et une source d'alimentation électrique, comprenant un filtre électronique (100) selon l'une des revendications précédentes.

8. Convertisseur de tension (320) selon la revendication précédente, comprenant des interrupteurs électroniques configurés pour recevoir un courant échangé avec la machine électrique et une carte électronique de contrôle configurée pour contrôler les états desdits interrupteurs électroniques, ladite carte électronique de contrôle comprenant la carte électronique (30) du filtre électronique (100).

9. Convertisseur de tension (320) selon la revendication précédente, dans lequel une première partie de la carte électronique (30) comprend ledit condensateur (32a-32h) du filtre électronique (100) et une deuxième partie de la carte électronique (30), différente de la première partie, comprend des composants destinés à contrôler les états desdits interrupteurs électroniques.

10. Equipement électrique comprenant une machine électrique (200) et un convertisseur de tension (320) selon l'une des revendications 7 à 9, dans lequel le convertisseur de tension (320) est monté sur la machine électrique (200).

11. Compresseur de suralimentation électrique, notamment pour véhicule automobile, comprenant un équipement électrique selon la revendication 10.

## Patentansprüche

1. Elektronischer Filter (100), der dazu bestimmt ist, die Einspeiseleistung eines elektrischen Geräts, insbesondere an Bord eines Kraftfahrzeugs, zu filtern, umfassend:
- eine elektrische Verbindungsleiste (10), die dazu bestimmt ist, eine elektrische Energie zwischen einer elektrischen Speisequelle und einer Elektromaschine auszutauschen, wobei die Verbindungsleiste (10) umfasst:
- eine positive Leistungsbahn (12) und eine negative Leistungsbahn (14) die dazu bestimmt sind, einen elektrischen Strom zwischen einem elektrischen Netz und der Elektromaschine zu vermitteln,
wobei die positive Leistungsbahn (12) und die negative Leistungsbahn (14) jeweils mindestens einen Verbindungsanschluss (24, 26) umfassen und teilweise mit elektrisch isolierendem Material (16) umspritzt sind,
- eine Induktivität (18), die elektrisch mit den positiven und negativen Leistungsbahnen (12, 14) verbunden ist,
- eine Aufnahmezone (20), die zum Aufnehmen der Induktivität (18) ausgebildet ist,
**dadurch gekennzeichnet, dass** der elektronische Filter (100) umfasst:
- eine Elektronikkarte (30), die Öffnungen (34), die den mindestens einen Verbindungsanschluss (24) der positiven Leistungsbahn (12) und den mindestens einen Verbindungsanschluss (26) der negativen Leistungsbahn (14) aufnehmen, und mindestens einen Kondensator (32a-32h) umfasst, wobei der mindestens eine Kondensator (32a-32h) der Elektronikkarte (30) elektrisch mit dem mindestens einen Verbindungsanschluss (24) der positiven Leistungsbahn (12) und dem mindestens einen Verbindungsanschluss (26) der negativen Leistungsbahn der elektronischen Verbindungsleiste (10) verbunden ist.

2. Elektronischer Filter nach Anspruch 1, wobei der Kondensator (32a-32h) auf der Elektronikkarte (30) oberflächenmontiert ist.

3. Elektronischer Filter nach einem der vorhergehenden Ansprüche, wobei die elektrische Verbindungsleiste (10) und die Elektronikkarte (30) gegenüberliegend angeordnet sind, so dass sich die Verbindungsanschlüsse (24, 26) der positiven und negativen Leistungsbahnen (14, 12) von der elektrischen Verbindungsleiste (10) in Richtung der Elektronikkarte (30) erstrecken.

4. Elektronischer Filter nach dem vorhergehenden Anspruch, wobei sich die Verbindungsanschlüsse (24, 26) der positiven und negativen Leistungsbahnen (24, 26) quer, insbesondere im Wesentlichen senkrecht, von der elektrischen Verbindungsleiste (10) in Richtung der Elektronikkarte (30) erstrecken.

5. Elektronischer Filter nach Anspruch 3 oder 4, wobei die Verbindungsanschlüsse (24, 26) in Form eines Stifts vorliegen, wobei die Elektronikkarte (30) und die Verbindungsanschlüsse (24, 26) so ausgebildet sind, dass die Verbindungsanschlüsse (24, 26) mit elektrischen Leiterbahnen der Elektronikkarte (30) elektrisch verbunden sind, die mit dem Kondensator (32a-32h) verbunden sind.

6. Elektronischer Filter nach einem der vorhergehenden Ansprüche, wobei die Elektronikkarte (30) einen ersten und einen zweiten Kondensator (32a-32d, 32e-32h) umfasst,
wobei die elektrische Verbindungsleiste (10) eine positive erste Leistungsbahn (12), die einen Verbindungsanschluss (26) umfasst, der elektrisch mit dem ersten Kondensator (32a-32d) verbunden ist, eine negative erste Leistungsbahn (14), die einen Verbindungsanschluss (24) umfasst, der elektrisch mit dem ersten Kondensator (32a-32d) verbunden ist, eine positive zweite Leistungsbahn (12), die einen Verbindungsanschluss (26) umfasst, der elektrisch mit dem zweiten Kondensator (32e-32h) verbunden ist, und eine negative zweite Leistungsbahn (14), die einen Verbindungsanschluss (24) umfasst, der elektrisch mit dem zweiten Kondensator (32e-32h) verbunden ist, umfasst,
wobei die Induktivität (18) elektrisch mit jeder der ersten und zweiten Leistungsbahnen (12, 14) verbunden ist.

7. Spannungswandler (320), der dazu bestimmt ist, eine elektrische Energie, die zwischen einer Elektromaschine (200) und einer elektrischen Speisequelle ausgetauscht wird, zu steuern, und einen elektronischen Filter (100) nach einem der vorhergehenden Ansprüche umfasst.

8. Spannungswandler (320) nach dem vorhergehenden Anspruch, umfassend elektronische Schalter, die dazu konfiguriert sind, einen Strom aufzunehmen, der mit der Elektromaschine und einer Steuerelektronikkarte ausgetauscht wird, die dazu konfiguriert ist, die Zustände der elektronischen Schalter zu steuern, wobei die Steuerelektronikkarte die Elektronikkarte (30) des elektronischen Filters (100) umfasst.

9. Spannungswandler (320) nach dem vorhergehenden Anspruch, wobei ein erster Teil der Elektronikkarte (30) den Kondensator (32a-32h) des elektronischen Filters (100) umfasst und ein zweiter Teil der Elektronikkarte (30), der vom ersten Teil verschieden ist, Komponenten umfasst, die dazu bestimmt sind, die Zustände der elektronischen Schalter zu steuern.

10. Elektrisches Gerät, das eine Elektromaschine (200) und einen Spannungswandler (320) nach einem der Ansprüche 7 bis 9 umfasst, wobei der Spannungswandler (320) an die Elektromaschine (200) montiert ist.

11. Elektrischer Verdichter, insbesondere für ein Kraftfahrzeug, der ein elektrisches Gerät nach Anspruch 10 umfasst.

## Claims

1. Electronic filter (100), intended to filter the power supplied to an item of electrical equipment, notably one installed in a motor vehicle, comprising:
- a busbar (10) intended to exchange electrical energy between an electric power source and an electric machine, the busbar (10) comprising:
- one positive power line (12) and one negative power line (14) intended to transmit an electric current between an electrical network and the electric machine, the positive power line (12) and the negative power line each comprising at least one connection terminal (24, 26) and being in part overmoulded with electrically insulating material (16),
- an inductor (18) electrically connected to the positive and negative power lines (12, 14),
- a receiving area (20) adapted to receive said inductor (18),
**characterized in that** the electronic filter (100) comprises:
- a printed circuit board (30) comprising holes (34) receiving the at least one connection terminal of the positive power line (12) and the at least one connection terminal of the negative power line (14) and at least one capacitor (32a-32h),
the at least one capacitor (32a-32h) of the printed circuit board (30) being electrically connected to said at least one connection terminal (24, 26) of the positive power line (12) and to the at least one connection terminal of the negative power line (14) of the busbar (10).

2. Electronic filter according to Claim 1, wherein the capacitor (32a-32h) is surface-mounted on the printed circuit board (30).

3. Electronic filter according to one of the preceding claims, wherein the busbar (10) and the printed circuit board (30) are arranged face to face, so that the connection terminals (24, 26) of the positive and negative power lines (14, 12) extend from the busbar (10) in the direction of the printed circuit board (30).

4. Electronic filter according to the preceding claim, wherein the connection terminals (24, 26) of the positive and negative power lines (24, 26) extend transversely, notably substantially perpendicularly, from the busbar (10) in the direction of the printed circuit board (30).

5. Electronic filter according to Claim 3 or 4, wherein the connection terminals (24, 26)are in the form of a pin, the printed circuit board (30) and the connection terminals (24, 26) being adapted so that the connection terminals (24, 26) are electrically connected to electrical traces of the printed circuit board (30) connected to the capacitor (32a-32h) .

6. Electronic filter according to one of the preceding claims, wherein the printed circuit board (30) comprises a first and a second capacitor (32a-32d, 32e-32h),
wherein the busbar (10) comprises a first positive power line (12) comprising a connection terminal (26) electrically connected to the first capacitor (32a-32d), a first negative power line (14) comprising a connection terminal (24) electrically connected to the first capacitor (32a-32d), a second positive power line (12) comprising a connection terminal (26) electrically connected to the second capacitor (32e-32h), and a second negative power line (14) comprising a connection terminal (24) electrically connected to the second capacitor (32e-32h),
wherein the inductor (18) is electrically connected to each of said first and second power lines (12, 14) .

7. Voltage converter (320) intended to control electrical energy exchanged between an electric machine (200) and an electric power source, comprising an electronic filter (100) according to one of the preceding claims.

8. Voltage converter (320) according to the preceding claim, comprising electronic switches configured to receive a current exchanged with the electric machine and a control printed circuit board configured to control the states of said electronic switches, said control printed circuit board comprising the printed circuit board (30) of the electronic filter (100).

9. Voltage converter (320) according to the preceding claim, wherein a first part of the printed circuit board (30) comprises said capacitor (32a-32h) of the electronic filter (100) and a second part of the printed circuit board (30), which is different from the first part, comprises components intended to control the states of said electronic switches.

10. Item of electrical equipment comprising an electric machine (200) and a voltage converter (320) according to one of Claims 7 to 9, wherein the voltage converter (320) is mounted on the electric machine (200).

11. Electric supercharger, notably for a motor vehicle, comprising an item of electrical equipment according to Claim 10.
